# EUROPEAN PATENT SPECIFICATION

(11) **EP 1 813 695 B1**
(45) Date of publication and mention of the grant of the patent: **11.05.2011**
(21) Application number: 07101310.6
(22) Date of filing: 29.01.2007
(51) Int. Cl.: C23C 14/34, H01J 37/34

(54) **Tubular sputtering target with improved stiffness**
Rohrförmiges Sputtertarget mit verbesserter Steifigkeit
Cible de pulvérisation tubulaire avec rigidité renforcée

(30) Priority: 31.01.2006 EP 06101089
(43) Date of publication of application: 01.08.2007
(73) Proprietor: Bekaert Advanced Coatings NV., 9800 Deinze (BE)
(72) Inventor: De Bosscher, Wilmert, 9031 Drongen (BE); Van de Putte, Ivan, 8800 Roeselare (BE)
(74) Representative: Messely, Marc

(56) References cited:
- US-A1- 2003 141 183
- US-B1- 6 488 824

## Description

### Field of the invention.

The invention relates to the field of rotatable sputtering targets such as used in large area coaters, display coaters, magnetic storage disc coaters, optical storage disc coaters and similar equipment, and the methods to manufacture such targets.

### Background of the invention.

In a low-pressure sputtering process, material is transferred from a target onto a substrate. Such transfer is realised by dislodging species -preferable single atoms - from the target by bombarding it with ions having a high kinetic energy. Ions are accelerated out of a glow discharge plasma by biasing the target negatively with respect to the plasma. The plasma can be kept in the vicinity of the target by maintaining a magnetic field just above the target surface, a process known as magnetron sputtering. When properly configured, the magnetic field will prevent the electrons from escaping the plasma so that they can maintain the ionisation degree of the plasma. The target can take many shapes depending on the specific application. For the purpose of this application only targets having a tubular or more preferably cylindrical shape are considered. Such tubular targets are made with an outer diameter of typically between 135 to 155 mm for 5" tubes and between 205 and 235 mm for 8" tubes and can have a length upto 4000 mm. Such targets comprise at least the 'target material' that one wants to transfer from target to substrate. The target material is disposed at the radially outer surface of the target over substantially its complete length. In addition to the target material, a 'backing tube' may or may not be present depending on the properties and the form in which the target material is available. Inside the tubular target a cooling fluid - usually water - is circulated during operation in order to prevent the target of excessive heating.

See US 2003/0141183 and US 6 488 824.

Various technologies are available for the manufacturing of tubular sputtering targets such as thermal spraying of the target material onto a backing tube, casting or extrusion of the target material, co-extrusion of backing tube together with the target material, dynamic flow-forming, hipping, sintering,... Each technology has its advantages and its limitations and the choice for a specific technology is often determined by the inherent or required material properties.

However, an important point of attention is the intrinsic strength of the material, which is reflected in the elasticity modulus E. More in particular the value of E at the elevated operational temperature of the target is important. Over and above the target material is consumed in the process and the tubular target thus gets thinner and thinner hence looses stiffness. If E is too low, long (non-reinforced) end supported cylindrical targets held in a horizontal position will suffer from sagging. In a sputter down configuration, this will lead to a shorter target-substrate distance close to center of the target compared to the distance at the target ends. If a stiff magnet bar with a limited bow is used within the cylindrical target tube, this could result in mechanical rubbing of the rotating inner target surface against the magnet bar, leading to damage. Both effects will cause serious deviations from a stable, robust and controlled sputter process with a good control of cross width uniformity that is sought for. A similar problem will occur in a substantially horizontal positioned target that is supported from a single end in a cantilevered configuration. Besides the bow due to drooping, which will be even more pronounced at the free end compared to the target supported at both ends, there is a similar risk of interference between the magnet bar and the inside of the target tube.

In practice, this 'lack of stiffness problem' is minor for thermally sprayed cylindrical targets because a high strength backing tube (typically stainless steel) is present anyhow. For target material that is castable, people try to cast onto a backing tube to ensure the mechanical strength of the complete structure. If an extruded structure would not have the desired mechanical strength and bow is too much as a result of gravity, the more complex co-extrusion of carrier tube and target material may be evaluated. Both solutions are not always easy, and depend on thermal behavior of target and backing tube material. Sometimes people try to bond the formed target material on a backing tube by using a bonding material (e.g. low melting point metal alloy). Also this methodology poses serious challenges (e.g. simultaneous heating of the target sleeve and backing tube) in order to flow the bonding material between target and backing tube.

Targets made by simply sliding (or even thermally shrink fitting, with or without heat sink paste) preformed target material sleeves over a backing tube and securing those sleeves in a mechanical way - as e.g. disclosed in WO 2004/005574 - also entails problems. During a sputter process, an important thermal load is transferred to the outer surface of the target material sleeve(s). The inner backing tube is not heated in the same way and is most probably water-cooled. Thermal expansion may cause the sleeves to expand radially and axially. Radial expansion will cause loss of contact with the backing tube and as a result with the cooling source, while axial expansion may exhibit large forces on and even mechanical deformation of the fixation rings that are used to hold the sleeves axially in place. Once a heat sink paste or bonding material starts loosing contact between the outside of the inner backing tube and inside of the outer target sleeve(s), the temperature of the sleeve(s) will increase rapidly and a destructive avalanche effect is obtained. An adequate cooling of the target material at all times is therefore indispensable.

### Summary of the invention.

The object of the invention is therefore to provide tubular targets that maintain their stiffness during use when target material is abraded away. Another object of the invention is to provide a target with improved cooling of the target material in order to reduce the heat load on the target as a whole.

The tubular target according the invention comprises a tubular supporting structure and target material disposed radially outward on said supporting structure. The supporting structure has openings in its mantle surface so that cooling liquid comes into direct contact with the target material. The openings have a smallest dimension or dimension. The smallest dimension of the opening is - within the context of this application - the diameter of the largest sphere that can still pass the opening in the mantle surface. In order to ensure a minimal stiffness of the supporting structure, the openings can not be too large and therefore the smallest dimension of the openings should not be too big. A convenient limitation is that the smallest dimension of each of those openings must at least be smaller than the inner diameter of the supporting structure. The inner diameter of the supporting structure is the diameter of the largest sphere that can still pass through the end openings of the tubular supporting structure. Equivalently: a sphere with the inner diameter of the supporting structure inserted into said structure from the ends cannot be removed through the openings in the mantle surface. The supporting structure extends preferably over the larger part of the total target length and is preferably centered over the length of the target. The supporting structure can take several physical forms such as the form of a tube having a polygonal or circular cross section. The inner diameter is then also equal to the diameter inscribed in a cross-section of the tubular support structure. For the sake of this application, a perforated plate that is rolled or bent up to the desired diameter having a slit over its entire length is also considered to be tubular as it meets the functionality requirements of the supporting structure. The width of the slit - measured perpendicular to its longitudinal dimension - corresponds then to the smallest dimension of the opening. The slit is then one of the openings. As a variant thereon: the slit does not have to be necessarily straight: a helical slit with a certain pitch is not excluded.

The openings in the supporting structure can also take the form of circumferential gaps. The gaps should be small relative to the inner diameter of the supporting structure in order to provide sufficient support. The width of the gaps then corresponds to the smallest dimension of the opening.

The material from which the supporting structure is made must be strong, temperature resistant and corrosion resistant. If the electrical resistivity of the target material is high it is preferred that the material of the supporting structure conducts electricity well. Conversely, it is not necessary that the support structure conducts electricity well if the target material does. The material of the support structure is preferably non-magnetic in order not to distort the magnetic field of the magnet bar. Preferred materials in this respect are of course metals and metal alloys such as titanium. Non-magnetic types of stainless steel are most preferred although other materials as glass, high performance plastics or ceramics could be envisaged in certain cases.

In all cases, a perforated tube may be used. The perforation itself plays an important role. The larger the fraction of perforation relative to the surface of the mantle, the more cooling fluid can directly contact the inner surface of the target material and hence improve the cooling. On the other hand, a larger fraction of perforation may result in a decrease of the mechanical strength of the supporting structure. The form of the perforation may play an important role as well. Certain shapes will realize an improved flow regime of fluid contacting the target sleeves, e.g. longitudinal openings along the flow path. Some shapes (e.g. ellipses) may result in the same fraction of openings while sustaining a higher mechanical strength than others with the same fraction of perforation. Preferably, the cooling fluid is lead along the axial length of the supporting structure and target sleeve when the larger dimension of said openings is oriented axially. Alternatively, a screw-like flow can be induced on the cooling fluid when the larger dimension of the openings is oriented substantially oblique to the axis of the supporting structure.

In an alternative embodiment one can make short - say with a length of the inner diameter - in a tube parallel to the axis of the tube and radially outwardly stretch it so that a substantially larger overall diameter is obtained resulting in a tubular stretched metal support structure.

The proposed solution is amongst others applicable to target materials that can be manufactured cylindrically without the need for a backing tube support. Such target materials come in the form of one or more sleeves. The supporting structure is slid axially into the one or more sleeves or vice versa the sleeves are axially pulled over the supporting structure. In this way the necessary mechanical strength of the target can be obtained. The case where one single sleeve can cover substantially the whole length of the target is most preferred as it allows more possibilities. The shape of the inner supporting structure is then preferably tube-like, however polygonal extruded (or rolled/bent) structures may result in cooling fluid running in between the inner supporting structure and the target sleeve(s). A similar result may be obtained by e.g. using a circular perforated tube as inner open supporting structure and target sleeves with an inner polygonal shape.

In order to prevent leakage of cooling fluid into the vacuum chamber, each end of each target sleeve must be provided with a sealing means between the sleeve and the inner supporting structure. The inner supporting structure should not have any openings at the sealing interface. The sealing means can be embodied in the form of a ring e.g. a polymer O-ring (e.g. made from Viton®) or a metal sealing ring (e.g. known under the brand name Helicoflex®). The inner supporting structure has one or more openings in the area beneath each sleeve to allow cooling fluid (e.g. water) to contact the inner side of the sleeves. The sealing means should prevent the cooling fluid from leaving the tube system other than through the foreseen cooling fluid inlet and outlet. Similarly, however less preferred, is a sealing means between two adjacent target sleeves (and not onto the supporting structure), while the outer sleeves have a sealing means at their extremities on the supporting structure.

The supporting structure can protrude out of the sleeve or the series of sleeves. A target fixture system can be provided at one or both protruding ends of the supporting structure. Such fixtures systems are known in the art and are e.g. US 5,591,314 describing a system wherein a helical groove receives a helical spring wire that locks into the mounting ring of the magnetron or WO 00/00766 wherein a mounting ring presses the flange of the fixture against the magnetron flange. If one or both of the outermost sleeves extends over one or both ends of the supporting structure, a target fixture can be formed in the extending sleeve end itself. This of course under the proviso that the target material is workable - which is generally not the case for ceramic materials - and is sufficiently strong to carry the complete (single end supported) or half (double end supported) of the target. If this is not the case, one could opt to affix an extension to the extending target material sleeve that on the one side is connectable to the magnetron block and on the other side connected to the extending sleeve. Connection to the sleeve can be achieved by inserting the extension and fixing them with screws or to thread the extension into the extending sleeve end or with any known means in the art (US 6756081).

When the direct contact between coolant and target material is less preferred due to e.g. corrosion of the target material, an alternative embodiment wherein a membrane is used can be considered. Such membrane must be extensible, be coolant tight and thermally conductive. The membrane is placed in between the inner supporting structure and the target sleeve(s). The tube like membrane is fastened leak tight onto the inner supporting structure, at least at both ends with e.g. a wire tie wrap or loop fastener. Due to the inner water pressure, the membrane will be pushed against the target sleeve(s) and the thermal conductivity of the membrane will sustain the cooling efficiency. In case the membrane is not electrically conductive an electrical connector ring can establish such connection at the ends of the sleeves.

As a further advantage of the invention, it can be noted that the supporting structure can be reused after the target material has been consumed up to its limit. In this way costly parts of a target - such as the target fixture - can be saved.

### Brief description of the drawings.

The invention will now be described into more detail with reference to the accompanying drawings wherein
- FIGURE 1 shows a cross-section of a first embodiment of the inventive target wherein the target fixture system is incorporated in the supporting structure.
- FIGURE 2 shows a cross-section of a second embodiment wherein the target fixture system is machined out of the protruding end of a target material sleeve.
- FIGURE 3a shows a detailed drawing of target where one single sleeve of target material has been used in which a target fixture system is attached.
- FIGURE 3b shows a detail of the target of FIGURE 3a wherein the details of the target fixture are enlarged.

### Description of the preferred embodiments of the invention.

In the following description of the drawings, the last two digits of the reference numbers represent like features in the different embodiments.

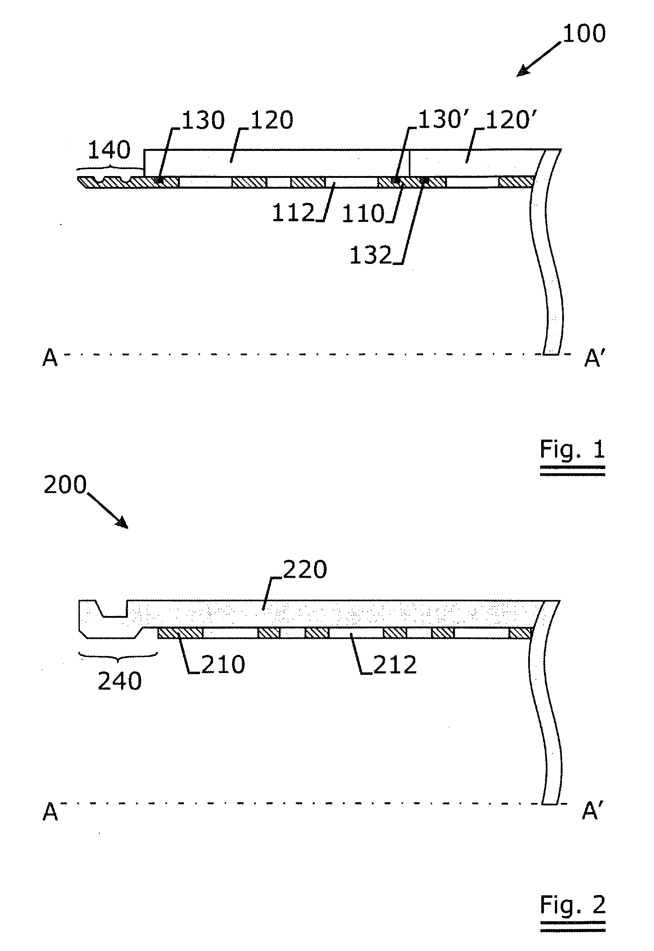

FIGURE 1 shows a target 100 assembled out of a supporting structure 110 that is in this embodiment a cylindrical stainless steel tube with axis A-A'. The supporting structure typically has a thickness between 3 to 10 mm, most preferred being the standard thickness as available from suppliers. The thickness of the supporting structure is function of the span to be covered by the target, the weight of the target and the diameter of the target. The tube has several openings 112 in it. At the outside of the tube different sleeves 120, 120' of target material are affixed. Such sleeves can be made from any kind of materials that can be sputtered such as metals (silver, zinc, copper etc...) or semimetals (such as carbon, tin, silicon, germanium,...) or alloys of them. Also certain types of oxides such indium alloyed tinoxide (ITO), or aluminium doped zinc oxide (ZOA), or titanium oxide to name just a few can be used as long as the materials can be provided in the form of cylindrical sleeves. The processes that are used to obtain such sleeves are diverse such as hot isostatic pressing (HIP), cold isostatic pressing (CIP), by means of casting, extrusion, cold forming, rolling or any other known method in the art.

When it is not possible to span the complete length of the target with one single sleeve, multiple sleeves can be used. The sleeves are slid over the supporting structure. This can be facilitated by heating the sleeves and cooling the supporting structure prior to assembly. Another method is to use a conical aid piece that is fixed to the end of the supporting structure over which one after the other the sleeves are slid. Sliding the sleeves further can be facilitated by axially tensioning the supporting structure.

In between the sleeves and the supporting structure vacuum-to-water seals 130; 130', 132,... must be present in order to prevent water entering the sputtering process. The sealing rings can be accommodated in a groove made in the target material sleeve, but by preference they fit into annular grooves made in the supporting structure. The sleeves themselves can be provided with a tongue-and-groove rim (not shown) in order to prevent that sputtering would be occur down to the supporting structure.

The, in this embodiment, protruding end 140 of the supporting structure is provided with a spiral groove made in the outside surface. A round spiral wire (not shown) fits into the groove and provides a thread for a collar spindle ring (not shown) providing a tight fitting to the mounting flange of a magnetron (in line with the disclosure US 5,591,314).

FIGURE 2 shows an alternate embodiment 200 wherein the supporting structure 210 does not protrude out of the sleeve. In this case only one sleeve 220 is present. No sealing is required as the supporting structure remains completely inside the sleeve. The target fixture 240 is milled out of the target material itself and comprises a collar that is gripped by a collar retaining ring (not shown). It will be clear to the person skilled in the art that the target material requirements enabling this embodiment are more demanding, as sleeves of the required length must be producible and those sleeves have to be workable in order to mill the collar out. On the other hand the proposal to use a supporting structure with a slit over its entire length and that is rolled out of a metal plate to a somewhat larger outer diameter than the inner diameter of the target material sleeve can be advantageously used. Prior to inserting the supporting structure into the sleeve to be reinforced, the slit is completely closed by means of a set of clamps that e.g. grip in the openings 212 or a number of provisory butt welds. Then the supporting structure is inserted into the sleeve. Once it is correctly positioned, the retaining clamps or welds are removed and the plate springs back elastically to its original diameter. In this way a tight fit with the target material sleeve is obtained. Such a fit can even be improved by applying - preferably electrically conductive - heat sink paste on the outer surface of the supporting structure prior to insertion. The supporting functionality of the structure is maintained even if the target material expands due to temperature increase as the elastic deformation of the structure follows the thermal expansion of the target sleeve while maintaining its support to the sleeve. As an alternative to using a rolled metal plate with a slit, one can use a standard tube provided with openings with a diameter that just fits the inner diameter of the target material sleeve. Again the tube is slid into the sleeve (with possible use of some heat sink paste). One can use the internal stresses that are present in a standard tube to one's advantage by making cuts from opening to opening so that a slit path forms from one end of the supporting structure to the other end. The cuts are made from the inside of the tube. Upon formation of this path, the tube will open due the internal stresses that always tend to open the tube. Another way to ease the step of sliding the support structure into the target material sleeve is to axially divide the support structure in two (or more) parts. The force needed to slide the first part of the support structure into the sleeve is halved and it has only to be slid in over half of the length of the tube. From the opposite end the second part can be slid in. If the two parts are close enough to one another, the loss in stiffness by the gap between the two parts will be minimal. Such a procedure could be advantageously used for very long targets.

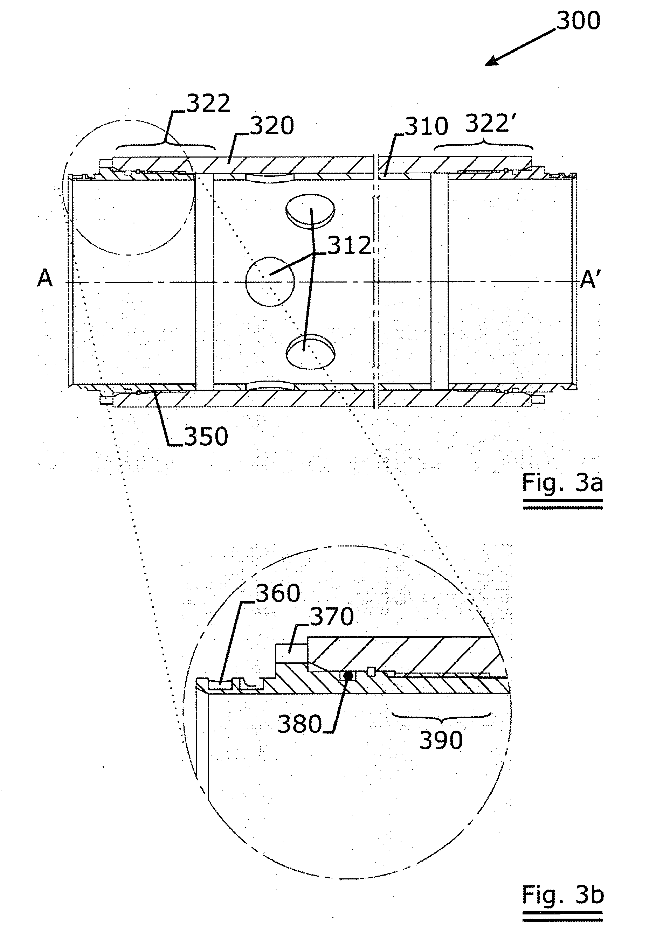

FIGURE 3a represents a third embodiment 300 of the invention that is useful when the target material is not fit to implement a target fixture in it. Again the already known features of supporting structure 310 with openings 312 on which target material 320 is disposed are discernable. The sleeve ends 322, 322' extend beyond the supporting structure. A separate extension 350 is now attached to the sleeve. The extension 350 is shown in greater detail in FIGURE 3b.

The end that is connectable to the magnetron is provided with appropriate grooves 360 that make such connection possible. An electrically insulating ring 370 protects the extension of being sputtered during operation. One or more O-rings 380 are provided to ensure that no coolant escapes from the target. The extension is attached to the target by means of a screw thread 390, or by means of appropriate adhesive means or by any other appropriate means known in the art.

The following claims define the subject matter for which protection is sought.

## Claims

1. A tubular target (100) comprising a tubular supporting structure (110) having an inner diameter and target material (120) disposed radially outward on said supporting structure (110) **characterised in that** said supporting structure (110) has one or more openings (112) in its mantle surface each of said openings having a smallest dimension that is smaller than said inner diameter.

2. The tubular target according to claim 1 wherein said supporting structure (110) has a polygonal or circular cross-section.

3. The tubular target according to any one of claim 1 to 2 wherein one of said openings (112) is a slit over the entire length of said supporting structure (110), the smallest dimension of said opening being the width of said slid.

4. The tubular target according to any one of claim 1 to 3 wherein one or more of said openings (112) are gaps over the circumference of said supporting structure (110), the smallest dimension of said opening being the width of said gap.

5. The tubular target according to any one of claim 1 to 4 wherein said openings (112) have a substantially elongated shape.

6. The tubular target according to claim 5 wherein said openings (112) have the shape of an ellipse or circle.

7. The tubular target according any one of claim 5 to 6 wherein the longer dimension of said openings (112) is oriented substantially parallel to the axis of said supporting structure (110).

8. The tubular target according any one of claim 5 to 6 wherein the longer dimension of said openings (112) is oriented substantially oblique to the axis of said supporting structure (110).

9. The tubular target according to any one of claim 1 to 8 wherein said target material (120) is provided in the form of one or more sleeves (120, 120') axially mountable on said supporting structure (110).

10. The tubular target according to claim 9 wherein sealing means (130, 130') are provided to seal the gap between said supporting structure (110) and said sleeves (120,120').

11. The tubular target according to claim 10 wherein sealing means are provided to seal the gap between sleeves (120, 120').

12. The tubular target according any one of claims 9 to 11 wherein said supporting structure (110) extends out of said sleeves (120, 120'), the extending end (140) of said supporting structure being provided with a target fixture system.

13. The tubular target (200) according any one of claims 9 to 11 wherein one (220) or both of the outer sleeves extends over said supporting structure, at least one or both of the outer ends (240) of said extending sleeves being provided with a target fixture system.

14. The tubular target (300) according to claim 13 further comprising one or two tubular extensions (350), said extension (350) comprising at one end a target fixture system (360) and at the other end an attachment system (390) for attaching said extension (350) to said extending sleeve end (322).

15. The tubular target according any of claims 1 to 14 further comprising a membrane, said membrane being placed between said supporting structure and said sleeves.

## Patentansprüche

1. Rohrförmiges Target (100), das eine rohrförmige Stützstruktur (110) mit einem Innendurchmesser und radial nach außen auf der Stützstruktur (110) angeordnetes Targetmaterial (120) umfasst, **dadurch gekennzeichnet, dass** die Stützstruktur (110) eine oder mehrere Öffnungen (112) auf ihrer Mantelfläche aufweist, wobei jede der Öffnungen eine kleinste Abmessung aufweist, die kleiner ist als der Innendurchmesser.

2. Rohrförmiges Target nach Anspruch 1, wobei die Stützstruktur (110) einen polygonalen oder kreisförmigen Querschnitt aufweist.

3. Rohrförmiges Target nach einem der Ansprüche 1 bis 2, wobei eine der Öffnungen (112) ein Schlitz über die gesamte Länge der Stützstruktur (110) ist, wobei die kleinste Abmessung der Öffnung die Breite des Schlitzes ist.

4. Rohrförmiges Target nach einem der Ansprüche 1 bis 3, wobei eine oder mehrere der Öffnungen (112) Spalten über den Umfang der Stützstruktur (110) ist bzw. sind, wobei die kleinste Abmessung der Öffnung die Breite des Spalts ist.

5. Rohrförmiges Target nach einem der Ansprüche 1 bis 4, wobei die Öffnungen (112) eine im Wesentlichen längliche Form aufweisen.

6. Rohrförmiges Target nach Anspruch 5, wobei die Öffnungen (112) die Form einer Ellipse oder eines Kreises aufweisen.

7. Rohrförmiges Target nach einem der Ansprüche 5 bis 6, wobei die längere Abmessung der Öffnungen (112) im Wesentlichen parallel zur Achse der Stützstruktur (110) ausgerichtet ist.

8. Rohrförmiges Target nach einem der Ansprüche 5 bis 6, wobei die längere Abmessung der Öffnungen (112) im Wesentlichen schräg zur Achse der Stützstruktur (110) ausgerichtet ist.

9. Rohrförmiges Target nach einem der Ansprüche 1 bis 8, wobei das Targetmaterial (120) in Form einer oder mehrerer Hülsen (120, 120') vorgesehen ist, die axial an der Stützstruktur (110) angebracht werden können.

10. Rohrförmiges Target nach Anspruch 9, wobei Dichtungsmittel (130, 130') vorgesehen sind, um den Spalt zwischen der Stützstruktur (110) und den Hülsen (120, 120') abzudichten.

11. Rohrförmiges Target nach Anspruch 10, wobei Dichtungsmittel vorgesehen sind, um den Spalt zwischen den Hülsen (120, 120') abzudichten.

12. Rohrförmiges Target nach einem der Ansprüche 9 bis 11, wobei sich die Stützstruktur (110) aus den Hülsen (120, 120') heraus erstreckt, wobei das vorstehende Ende (140) der Stützstruktur mit einem Targethalterungssystem versehen ist.

13. Rohrförmiges Target (200) nach einem der Ansprüche 9 bis 11, wobei sich eine (220) oder beide der äußeren Hülsen über die Stützstruktur erstreckt bzw. erstrecken, wobei mindestens eines oder beide der äußeren Enden (240) der vorstehenden Hülsen mit einem Targethalterungssystem versehen ist bzw. sind.

14. Rohrförmiges Target (300) nach Anspruch 13, das weiterhin eine oder zwei rohrförmige Verlängerungen (350) umfasst, wobei die Verlängerung (350) an einem Ende ein Targethalterungssystem (360) und am anderen Ende ein Befestigungssystem (390) zur Befestigung der Verlängerung (350) an dem vorstehenden Hülsenende (322) umfasst.

15. Rohrförmiges Target nach einem der Ansprüche 1 bis 14, das weiterhin eine Membran umfasst, wobei die Membran zwischen der Stützstruktur und den Hülsen platziert ist.

## Revendications

1. Cible tubulaire (100) comprenant une structure tubulaire de support (110) présentant un diamètre intérieur et un matériau de cible (120) disposé radialement à l'extérieur de ladite structure de support (110),
**caractérisée en ce que**
ladite structure de support (110) présente une ou plusieurs ouvertures (112) dans sa surface d'enveloppe et
**en ce que** la plus petite dimension de chacune desdites ouvertures est plus petite que ledit diamètre intérieur.

2. Cible tubulaire selon la revendication 1, dans laquelle la section transversale de ladite structure de support (110) est polygonale ou circulaire.

3. Cible tubulaire selon l'une quelconque des revendications 1 et 2, dans laquelle l'une desdites ouvertures (112) est une fente qui s'étend sur toute la longueur de ladite structure de support (110), la plus petite dimension de ladite ouverture étant la largeur de ladite fente.

4. Cible tubulaire selon l'une quelconque des revendications 1 à 3, dans laquelle une ou plusieurs desdites ouvertures (112) sont des interstices qui s'étendent sur la circonférence de ladite structure de support (110), la plus petite dimension de ladite ouverture étant la largeur dudit interstice.

5. Cible tubulaire selon l'une quelconque des revendications 1 à 4, dans laquelle lesdites ouvertures (112) ont une forme essentiellement allongée.

6. Cible tubulaire selon la revendication 5, dans laquelle lesdites ouvertures (112) ont la forme d'une ellipse ou d'un cercle.

7. Cible tubulaire selon l'une quelconque des revendications 5 à 6, dans laquelle la plus grande dimension desdites ouvertures (112) est orientée essentiellement en parallèle à l'axe de ladite structure de support (110).

8. Cible tubulaire selon l'une quelconque des revendications 5 à 6, dans laquelle la plus grande dimension desdites ouvertures (112) est orientée essentiellement obliquement par rapport à l'axe de ladite structure de support (110).

9. Cible tubulaire selon l'une quelconque des revendications 1 à 8, dans laquelle ledit matériau de cible (120) est prévu sous la forme d'un ou plusieurs manchons (120, 120') qui peuvent être montés axialement sur ladite structure de support (110).

10. Cible tubulaire selon la revendication 9, dans laquelle des moyens d'étanchéité (130, 130') sont prévus pour fermer hermétiquement l'interstice entre ladite structure de support (110) et les dimensions (120, 120').

11. Cible tubulaire selon la revendication 10, dans laquelle des moyens d'étanchéité sont prévus pour fermer hermétiquement l'interstice entre les manchons (120, 120').

12. Cible tubulaire selon l'une quelconque des revendications 9 à 11, dans laquelle ladite structure de support (110) s'étend au-delà desdits manchons (120, 120'), le prolongement de l'extrémité (140) de ladite structure de support étant doté d'un système de fixation de cible.

13. Cible tubulaire (200) selon l'une quelconque des revendications 9 à 11, dans laquelle un manchon extérieur (220) ou les deux manchons extérieurs s'étendent sur ladite structure de support, au moins l'une des deux extrémités extérieures (240) desdits prolongements des manchons étant dotée d'un système de fixation de cible.

14. Cible tubulaire (300) selon la revendication 13, qui comprend en outre un ou deux prolongements tubulaires (350), lesdits prolongements (350) comprenant à une extrémité un système (360) de fixation de cible et à l'autre extrémité un système de fixation (390) qui fixe ledit prolongement (350) sur ledit prolongement de l'extrémité (322) du manchon.

15. Cible tubulaire selon l'une quelconque des revendications 1 à 14, comprenant en outre une membrane, ladite membrane étant placée entre ladite structure de support et lesdits manchons.
